(19) Europäisches Patentamt
European Patent Office
Office européen des brevets

(11) **EP 4 610 725 A1**

(12) **EUROPEAN PATENT APPLICATION**

(43) Date of publication:
**03.09.2025 Bulletin 2025/36**

(21) Application number: **24159900.0**

(22) Date of filing: **27.02.2024**

(51) International Patent Classification (IPC):
*G03F 7/00* (2006.01)

(52) Cooperative Patent Classification (CPC):
**G03F 7/706849; G03F 7/706851**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **ASML Netherlands B.V.
5500 AH Veldhoven (NL)**

(72) Inventors:
• **VAN PUTTEN, Eibert, Gerjan
5500 AH Veldhoven (NL)**
• **ZHOU, Zili
5500 AH Veldhoven (NL)**
• **COENE, Willem, Marie, Julia, Marcel
5500 AH Veldhoven (NL)**
• **TINNEMANS, Patricius, Aloysius, Jacobus
5500 AH Veldhoven (NL)**

(74) Representative: **ASML Netherlands B.V.
Corporate Intellectual Property
P.O. Box 324
5500 AH Veldhoven (NL)**

(54) **METROLOGY METHOD AND ASSOCIATED METROLOGY DEVICE**

(57)     Disclosed is a metrology apparatus and method. The method comprises: obtaining metrology data relating to a measurement obtained by illuminating a periodic structure with illumination and capturing the resultant scattered radiation from said periodic structure at a detection plane, said scattered radiation passing through at least one detection angularly resolved plane between said periodic structure and detection plane, wherein said illumination comprises an even plurality of monopoles arranged within an illumination angularly resolved plane in one or more coherence groups, wherein each coherence group comprises a respective at least one mutually coherent dipole of said even plurality of monopoles which are all mutually coherent and wherein zeroth order reflection corresponding to all but one monopole for each said one or more coherence groups is blocked or attenuated within said detection angularly resolved plane; non-iteratively reconstructing a field of said scattered radiation.

Fig. 8

## Description

FIELD

The present invention relates to a metrology method and device which may, for example, be used for determining a characteristic of structures on a substrate.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as $CD = k_1 \times \lambda / NA$, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

In lithographic processes, it is desirable to make frequently measurements of the structures created, e.g., for process control and verification. Various tools for making such measurements are known, including scanning electron microscopes or various forms of metrology apparatuses, such as scatterometers. A general term to refer to such tools may be metrology apparatuses or inspection apparatuses.

In many metrology applications, it is desirable to access the full electric field (i.e., intensity and phase) rather than only intensity. Holography tools enable this, however they require a reference beam and very stringent operation to ensure interference between the reference beam and measurement radiation beam. Other phase retrieval methods may comprise an iterative retrieval of phase, however these are computationally demanding,

It would be desirable to improve on present methods for measuring the full electric field in metrology applications.

SUMMARY

Embodiments of the invention are disclosed in the claims and in the detailed description.

In a first aspect of the invention there is provided a metrology apparatus, comprising: an illuminator being operable to generate illumination comprising an even plurality of monopoles arranged within an illumination angularly resolved plane in one or more coherence groups, wherein each coherence group comprises a respective at least one mutually coherent dipole of said even plurality of monopoles which are all at least pointwise mutually coherent; projection optics for projecting said illumination onto a periodic structure on a substrate at a substrate plane; a stop in a detection angularly resolved plane between the substrate plane and a detection plane, being operable to block or attenuate zeroth order reflection corresponding to all but one monopole for each said one or more coherence groups, the zeroth order reflection being comprised within scattered radiation resulting from illumination of said periodic structure; and a detector for detecting at least a portion of the scattered radiation at the detection plane.

In a second aspect of the invention there is provided a metrology method comprising: obtaining metrology data relating to a measurement obtained by illuminating a periodic structure with illumination and capturing the resultant scattered radiation from said periodic structure at a detection plane, said scattered radiation passing through at least one detection angularly resolved plane between said periodic structure and detection plane, wherein said illumination comprises an even plurality of monopoles arranged within an illumination angularly resolved plane in one or more coherence groups, wherein each coherence group comprises a respective at least one mutually coherent dipole of said even plurality of monopoles which are all mutually coherent and wherein zeroth order reflection corresponding to all but one monopole for each said one or more coherence groups is blocked or attenuated within said detection angularly resolved plane; non-iteratively reconstructing a field of said scattered radiation; and using said reconstructed field to determine a parameter of interest of the structure.

In a third aspect of the invention there is provided a metrology method comprising: obtaining metrology data relating to a measurement obtained by illuminating a periodic structure with dipole illumination and capturing the resultant scattered radiation from said periodic structure at a detection plane, said scattered radiation passing through at least one detection angularly resolved plane between said periodic structure and detection plane, wherein each monopole of the dipole illumination is symmetrically opposed within an illumination numerical aperture and aligned within the illumination numerical aperture along a line at 45 degrees with respect to a coordinate system defined by a first measurement direction and a second measurement direction of said periodic structure, the scattered radiation corresponding to each monopole being directed, at said detection angularly resolved plane, to a respective different region of said detection plane; non-iteratively reconstructing a field of said scattered radiation; and using said reconstructed field to determine a parameter of interest of the structure.

In a fourth aspect of the invention there is provided a metrology apparatus, comprising: an illuminator being operable to generate dipole illumination wherein each monopole of the dipole illumination is symmetrically opposed within an illumination numerical aperture and aligned within the illumination numerical aperture along a line at 45 degrees with respect to a coordinate system defined by a first measurement direction and a second measurement direction of a periodic structure being measured; projection optics for projecting said illumination onto the periodic structure on a substrate at a substrate plane; a two-fold wedge element at a detection angularly resolved plane between said substrate plane and a detection plane, being operable to divert a first portion of said scattered radiation corresponding to a first monopole of said dipole illumination to a first portion of the detection plane; and divert a second portion of said scattered radiation corresponding to a second monopole of said dipole illumination to a second portion of the detection plane; and at least one detector at the detection plane for detecting said first portion of the scattered radiation and said second portion of the scattered radiation.

These and other aspects and advantages of the apparatus and methods disclosed herein will be appreciated from a consideration of the following description and drawings of exemplary embodiments.

BRIEF DESCRIPTION OF THE DRAWINGS

Embodiments of the invention will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 is a schematic illustration of a scatterometry apparatus;
- Figure 5 comprises (a) a schematic diagram of a dark field scatterometer for use in measuring targets according to embodiments of the invention using a first pair of illumination apertures, (b) a detail of diffraction spectrum of a target grating for a given direction of illumination (c) a second pair of illumination apertures providing further illumination modes in using the scatterometer for diffraction based overlay measurements (d) a third pair of illumination apertures combining the first and second pair of apertures;
- Figure 6 is a schematic illustration of a detection pupil corresponding to a proposed metrology arrangement using dipole illumination;
- Figure 7(a) is a schematic illustration of an illumination pupil for a proposed metrology arrangement using a dipole illumination arrangement; Figure 7(b) is a schematic illustration of an illumination pupil for a proposed metrology arrangement using a first quadrupole illumination arrangement; and Figure 7(c) is a schematic illustration of an illumination pupil for a proposed metrology arrangement using a second quadrupole illumination arrangement;
- Figure 8(a) is a schematic illustration of a detection pupil for a proposed metrology arrangement using the dipole illumination arrangement of Figure 7(a); Figure 8(b) is a schematic illustration of a detection pupil for a proposed metrology arrangement using the first quadrupole illumination arrangement of Figure 7(b); and Figure 8(c) is a schematic illustration of a detection pupil for a proposed metrology arrangement using the second quadrupole illumination arrangement of Figure 7(c);
- Figure 9(a) is a schematic illustration of an intensity spectrum obtained using the dipole illumination arrangement of Figure 7(a); Figure 9(b) is a schematic illustration of an intensity spectrum obtained using the first quadrupole illumination arrangement of Figure 7(b); and Figure 9(c) is a schematic illustration of an intensity spectrum obtained using the second quadrupole illumination arrangement of Figure 7(c);

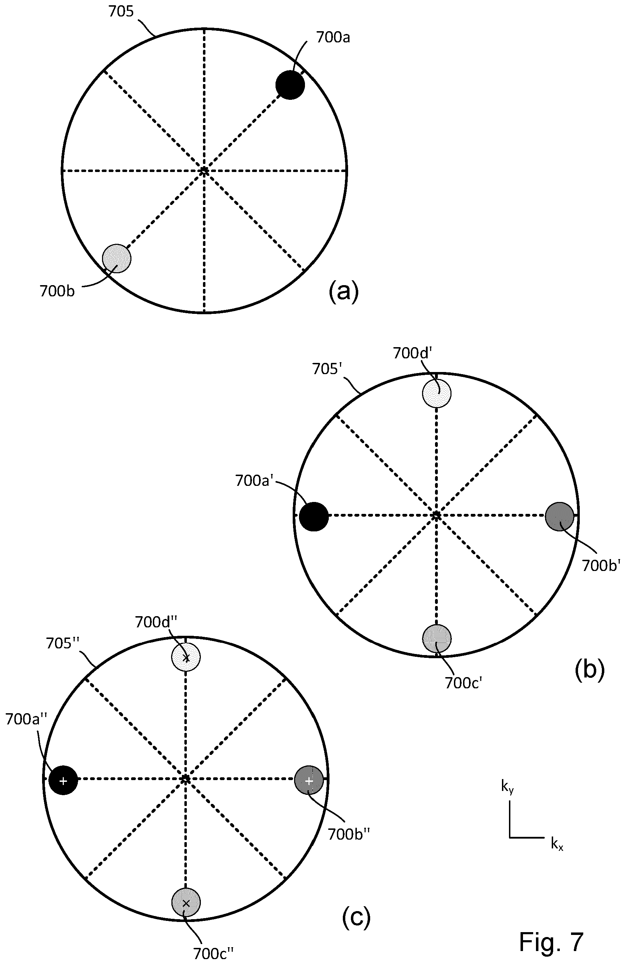

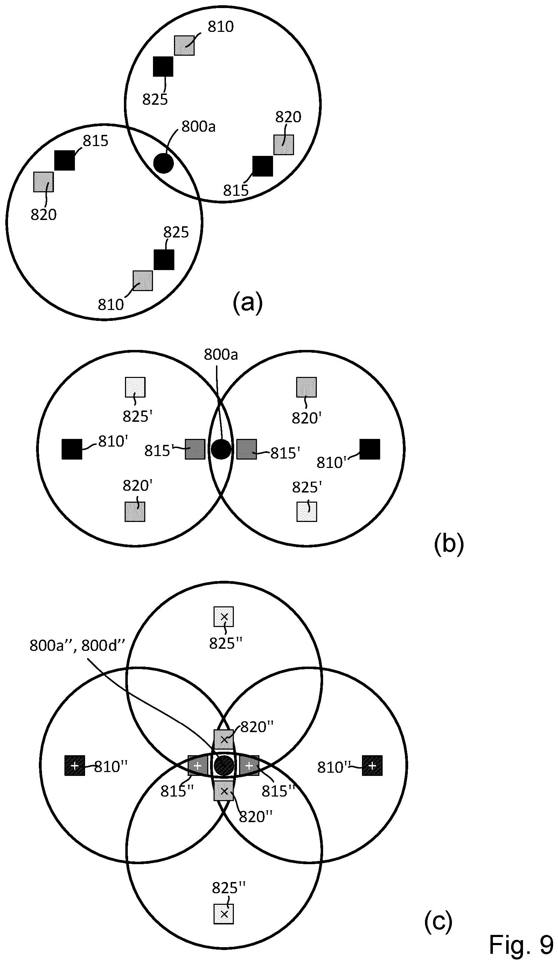

- Figure 9(a) is a schematic illustration of an intensity spectrum obtained using the dipole illumination arrangement of Figure 7(a); Figure 9(b) is a schematic illustration of an intensity spectrum obtained using the first quadrupole illumination arrangement of Figure 7(b); and Figure 9(c) is a schematic illustration of an intensity spectrum obtained using the second quadrupole illumination arrangement of Figure 7(c);

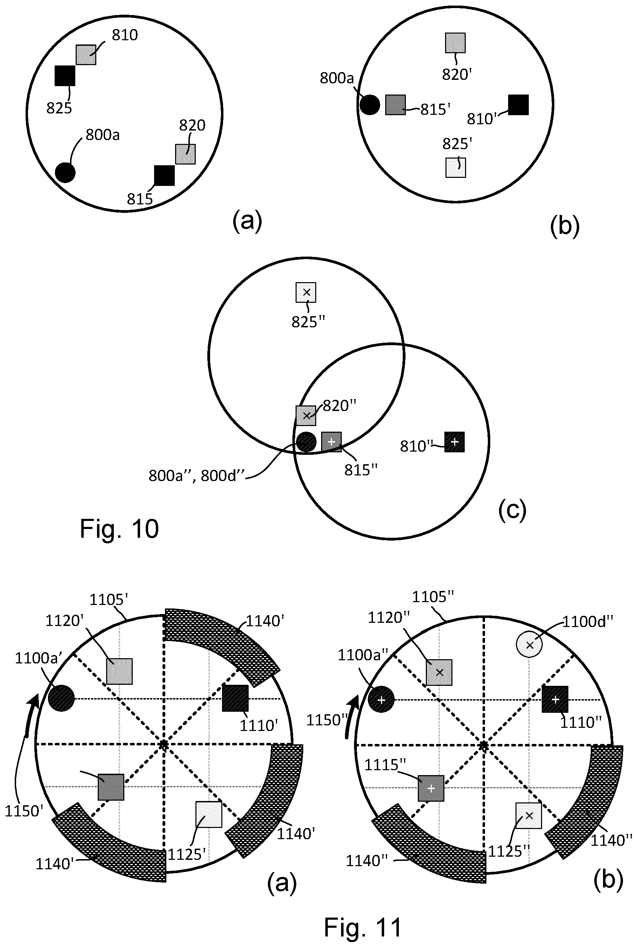

- Figure 10(a) is a schematic illustration of the reconstructed detection pupil corresponding to the intensity spectrum of Figure 9(a); Figure 10(b) is a schematic illustration of the reconstructed detection pupil corresponding to the intensity spectrum of Figure 9(b); and Figure 10(c) is a schematic illustration of the reconstructed detection pupil corresponding to the intensity spectrum of Figure 9(c);

- Figure 11(a) is a schematic illustration of a detection pupil for a proposed metrology arrangement using the first quadrupole illumination arrangement for which the illumination arrangement has been rotated with respect to the detection pupil; and Figure 11(b) is a schematic illustration of a detection pupil for a proposed metrology arrangement using the second quadrupole illumination arrangement for which the illumination arrangement has been rotated with respect to the detection pupil;

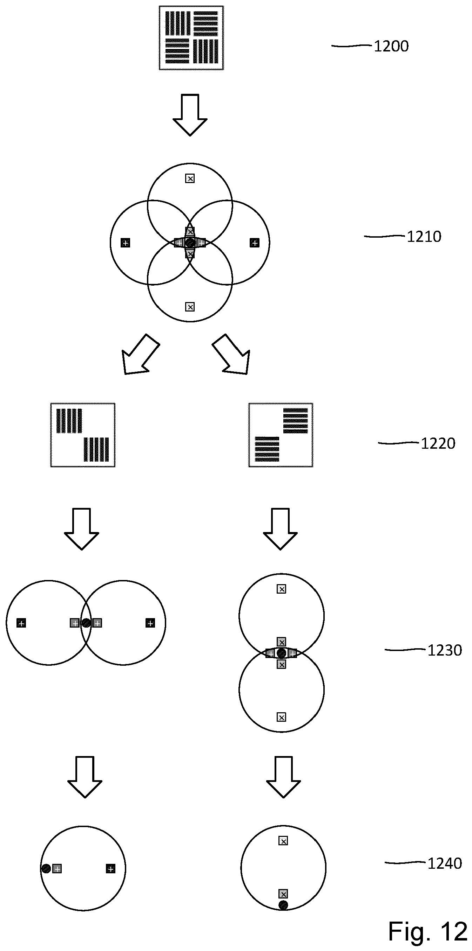

- Figure 12 is a flow diagram of a proposed method of spatially filtering the measured intensity image before applying the phase retrieval algorithm so as to separate the contributions from different coherence groups; and

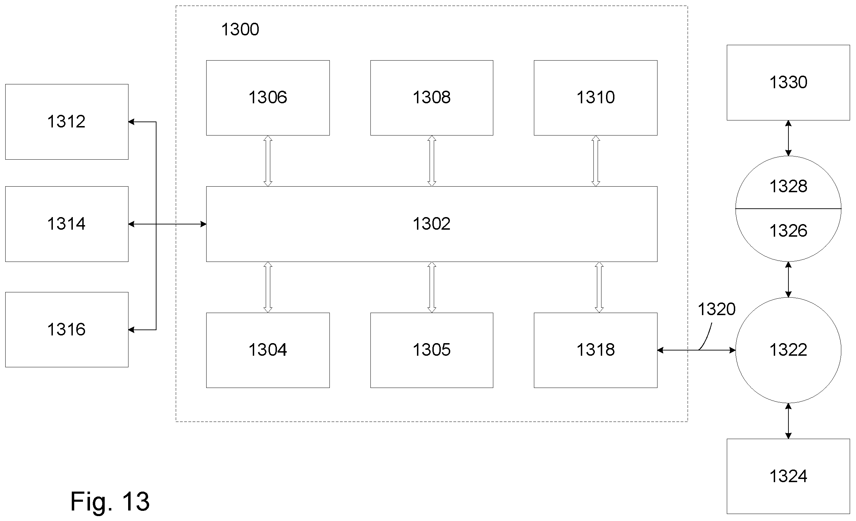

- Figure 13 depicts a block diagram of a computer system for controlling a metrology method and/or device such as disclosed herein.

## DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

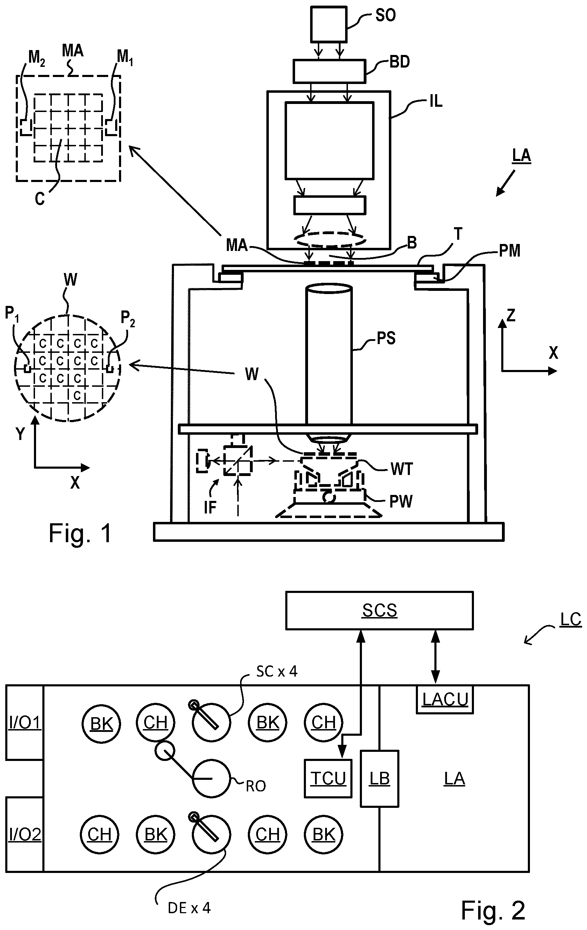

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

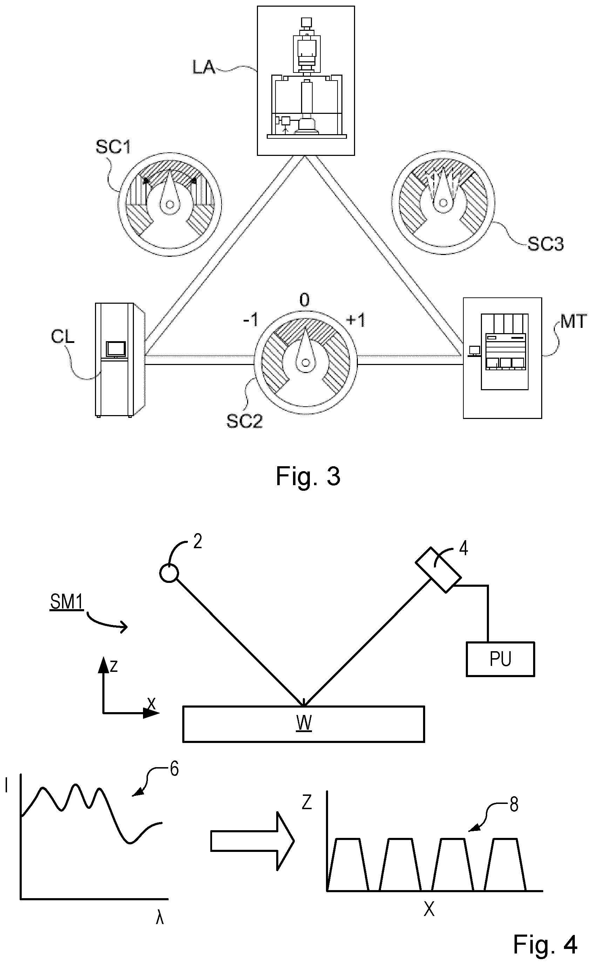

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Figure 3. One of these systems is the lithographic apparatus LA which is (virtually) connected to a metrology tool MET (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Figure 3 by the arrow pointing "0" in the second scale SC2).

The metrology tool MET may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third scale SC3).

In lithographic processes, it is desirable to make frequently measurements of the structures created, e.g., for process control and verification. Various tools for making such measurements are known, including scanning electron microscopes or various forms of metrology apparatuses, such as scatterometers. Examples of known scatterometers often rely on provision of dedicated metrology targets, such as underfilled targets (a target, in the form of a simple grating or overlapping gratings in different layers, that is large enough that a measurement beam generates a spot that is smaller than the grating) or overfilled targets (whereby the illumination spot partially or completely contains the target). Further, the use of metrology tools, for example an angular resolved scatterometer illuminating an underfilled target, such as a grating, allows the use of so-called reconstruction methods where the properties of the grating can be calculated by simulating interaction of scattered radiation with a mathematical model of the target structure and comparing the simulation results with those of a measurement. Parameters of the model are adjusted until the simulated interaction produces a diffraction pattern similar to that observed from the real target.

Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers ca measure in one image multiple targets from multiple gratings using light from soft x-ray and visible to near-IR wave range.

A metrology apparatus, such as a scatterometer, is depicted in Figure 4. It comprises a broadband (white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength $\lambda$) of the specular reflected radiation 10. From this data, the structure or profile 8 giving rise to the detected spectrum may be reconstructed by processing unit PU, e.g. by Rigorous Coupled Wave Analysis and non-linear regression or by comparison with a library of simulated spectra. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety. Other parameters of interest may be focus and dose. Focus and dose may be determined simultaneously by scatterometry (or alternatively by scanning electron microscopy) as described in US patent application US2011-0249244, incorporated herein by reference in its entirety.

The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

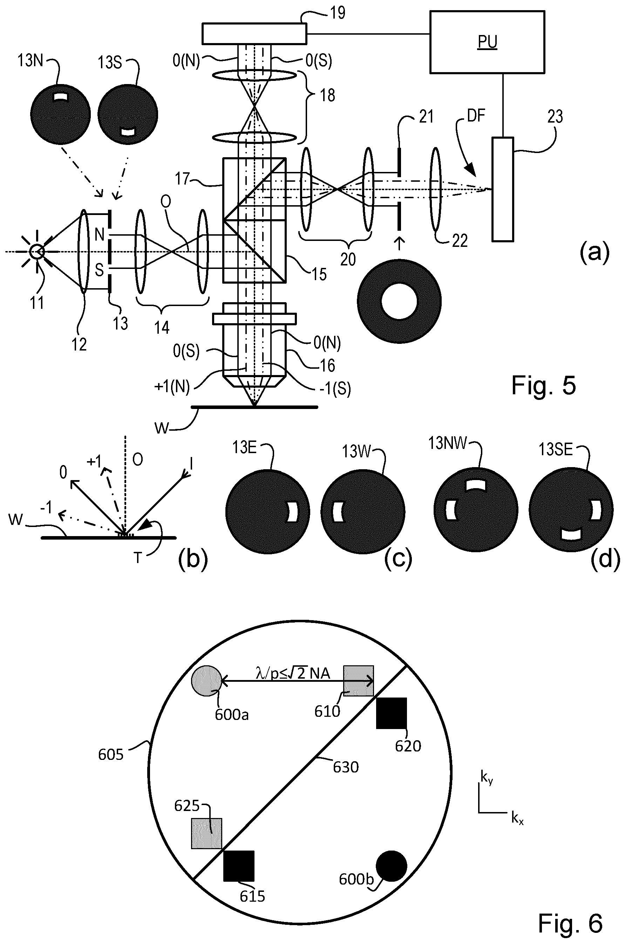

Figure 5(a) presents an embodiment of a metrology apparatus and, more specifically, a dark field scatterometer. A target T and diffracted rays of measurement radiation used to illuminate the target are illustrated in more detail in Figure 5(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 11 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane or angularly resolved plane. In particular, this can be done by inserting an aperture plate 13 of suitable form between lenses 12 and 11, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 5(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 5(a) and 5(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 5(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 5 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 5) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 5(c) and (d). The use of these, and numerous other variations and applications of the apparatus are described in prior published applications, mentioned above.

As an alternative to a scatterometer, a metrology device may comprise a holographic microscope such as a digital holographic microscope (DHM) or digital dark-field holographic microscope. Such as device is disclosed, for example, in US2019/0107781 and WO2021121733A1 both of which is incorporated herein by reference.

In a scatterometry metrology tool, light may be used to create an image (e.g., at one or both of an image plane or pupil plane/angularly resolved plane) of a structure on a substrate. Such tools may measure the intensity or amplitude (or related measurement parameter such as diffraction efficiency) of the detected light, e.g., after having been scattered by the structure, and use this to determine one or more parameters of interest of the structure. In many cases, it may be beneficial to know the complex field (i.e., amplitude and phase) of the light scattered by the structure.

There are a number of present methods which enable the phase to be determined, in addition to the measured intensity/amplitude. One such technology is the aforementioned DHM, however holographic methods are typically subject to strict stability requirements and/or very low acquisition times, to suppress mechanical vibrations and/or drift and therefore achieve the necessary interference of the scattered radiation with reference radiation at the detector.

Another known method comprises performing multiple measurements under various conditions (e.g., different focus levels) and reconstructing the complex field of the scattered light using an iterative algorithm (e.g. as described in WO2021/121733, incorporated herein by reference). However, such methods are computationally very demanding/expensive and can be slow as a consequence, particularly as the accuracy of the retrieved phase is required to be higher in metrology than for more conventional phase retrieval applications such as microscopy and which require only the formation of an image. Other technologies are also known such as using masks having a pinhole or similar aperture in the detection branch of the tool, which allows an interferometric measurement (e.g. as described in WO2020/254041, incorporated herein by reference).

A non-iterative method for determining the complex field of the scattered radiation will now be described, based on causality, such as which applies in the (one-dimensional) time versus angular frequency context. This time causality stems from the fact that the electric field cannot travel faster than the speed of light, leading to an electric field $E$=0 for a time $t$<0 constraint. This time/causality constraint leads to a symmetry relationship of the electric field in the angular frequency domain. This symmetry relation is often referred to as the Kramers-Kronig relationship (and its inverse, which is the second Kramers-Kronig relationship). In an optical analogy of this concept, the time constraint may be replaced/implemented by locating a mask in the pupil plane (i.e., angularly resolved plane), such that the time coordinate $t$ becomes the pupil coordinate, and the angular frequency coordinate $\omega$ becomes the sensor/camera (image plane) coordinate. Because the Kramers-Kronig relationship comprises a linear integral transform (in essence a convolution operation), the (one-dimensional) Kramers-Kronig expression(s), expressed in terms of Fourier transforms, may be extended into a two-dimensional analysis; i.e., the two dimensions of the pupil plane/image plane.

Applying the Kramers-Kronig relationship to non-iteratively extract phase information, and therefore the full field, requires applying the phase extraction algorithm to an intensity image which is the result of an optical field having a single-sided spectrum. Typically, this may be achieved by filtering out one side of spectrum (e.g., with respect to the specular beam) using a physical mask within the pupil plane. For example, the pupil edge may be used as the mask, e.g., by centering the specular beam (or each diffracted/scattered beam of interest in a dark-field embodiment) on the pupil edge in the pupil plane such that the edge clips (i.e., blocks) half of the beam.

However, masking the beam is non-optimal as it limits applicability of Kramers-Kronig based methods using, for example, a setup such as that illustrated in Figure 5(a) to certain situations such as a limited usable λ/p range (where λ is the wavelength(s) of the measurement radiation used and p is the target pitch) and/or limited coherence conditions for the measurement radiation and/or requires the provision of a dedicated mask in the pupil plane (which is not desirable).

In addition, present Kramers-Kronig based methods are typically employed in combination with the use of coherent illumination, e.g., for performing microscopy. For microscopy to work, it is important to reconstruct the full complex field accurately. Due to this requirement, a strict alignment of the specular reflection with the mask is required, as any misalignment would introduce an error term on the reconstructed field (due to the requirement for a single-sided spectrum), thereby introducing unwanted artifacts in the resulting microscopy image. However, it may be preferable to use illumination which is not coherent, e.g., partial coherent radiation. In particular, many present metrology apparatuses (e.g., such as that illustrated in Figure 5(a)) already use partial coherent illumination and it is desirable to use such apparatuses for non-iterative phase retrieval without significant hardware/source changes or spatial filtering of the light source, the latter option coming at the expense of light throughput. Also, using a coherent source makes the system sensitive to coherent imaging artifacts and reduces the robustness of any practical implementation due to the strict alignment requirements of the beam with respect to the mask.

Arrangements described herein may be used for example, in diffraction based metrology such as diffraction based overlay (DBO) or diffraction based focus (DBF) metrology. Diffraction based metrology such as DBO/DBF comprises comparing complementary diffraction orders (i.e., diffraction orders of the same order number either side of the specular beam such as the +1 and -1 diffraction orders; i.e., diffraction orders having the same magnitude diffraction angle with respect to the specular beam) to determine an asymmetry in the scattering structure or target, from which a parameter of interest (e.g., overlay or focus) can be extracted. The proposed method may comprise properly selecting wavelength and target pitch (e.g., $\lambda/p$ ratio) to enable suitable reconstruction of the electric field.

Figure 6 illustrates a proposed alternative arrangement to those presently used, which enables greater flexibility in that it provides for the option of using partial coherent illumination rather than fully coherent illumination (although coherent illumination may be used).

In such an arrangement, a dipole illumination is used, resulting in respective specular beams 600a, 600b in two opposed regions within the exit pupil 605 (i.e., representing the detection NA, with a value $NA$ for the detection NA described by the radius of the pupil). For example, the specular beams 600a, 600b may be diagonally opposed with respect to a pupil coordinate system $k_x$, $k_y$ defined by the measurement directions X, Y, e.g., 45 degrees with respect to this pupil coordinate system). One each of the +1X diffraction order 610, -1X diffraction order 615, +1Y diffraction order 620 and -1Y diffraction order 625 is captured within the detection NA 605. A diagonally oriented two-fold wedge having an edge 630 separating the exit-pupil into two equally sized halves allows simultaneous imaging of the two specular beams 600a, 600b and four diffraction orders 610, 615, 620, 625. As such, single acquisition or "single-shot" non-iterative phase retrieval for parameter of interest and/or diffraction based metrology, in two perpendicular directions of the substrate plane (e.g., X and Y directions), is possible using such an arrangement.

Note that the shading does not indicate that the two specular beams 600a, 600b and their respective diffraction orders are different, only to illustrate which captured diffraction order relates to which of the specular beams 600a, 600b (e.g., +1X diffraction order 610 and -1Y diffraction order 625 are part of the same diffraction pattern as specular beam 600a and, -1X diffraction order 615 and +1Y diffraction order 620 are part of the same diffraction pattern as specular beam 600b). Also note that the diffracted orders are represented as square solely to differentiate then from the specular beams in the drawing.

The theoretical maximum wavelength-over-pitch ($\lambda/p$) ratio of standard diffraction based metrology (e.g., using a metrology tool such as illustrated in Figure 5(a)) presently comprises twice the detection NA (e.g., in each respective measurement direction X, Y). By contrast, the arrangement illustrated in Figure 6, as is illustrated, comprises a maximum wavelength-over-pitch ($\lambda/p$) of $\sqrt{2}NA$, and therefore suffers from a loss in usable $\lambda/p$ range of a factor $\sqrt{2}$. Secondly, this approach uses a 2-fold wedge as an optical element in the detection path; a solution without such a wedge is in principle advantageous.

Therefore, further improvements are proposed which further increase the usable $\lambda/p$ range (e.g., to approximately 2$NA$ for at least some embodiments) and/or enable non-coherent (e.g., such as partial coherent) illumination to be used.

To achieve this, it is proposed to use an illumination configuration comprising an even number of illumination monopoles (e.g., dipole, quadrupole illumination or other n-pole illumination where n is an even integer) in the illumination pupil (an illumination numerical aperture within an illumination angularly resolved plane). The illumination monopoles are distributed evenly around the illumination pupil (i.e., equally spaced in terms of angle). The illumination monopoles may all be located at a peripheral region of the pupil, e.g., evenly spaced along the edge of the illumination pupil. The illumination monopoles may be equally distanced from a center of the pupil.

The illumination monopoles are arranged in one or more mutually coherent pairs or mutually coherent dipoles, with each monopole of a mutually coherent dipole being located on opposite sides of the pupil (e.g., symmetrically opposite within the pupil). Opposite sides of the pupil may be understood to mean either side of, linearly aligned with and equally spaced from the pupil center (e.g., at the periphery of the pupil, near the edge). Each of the mutually coherent dipoles comprises two monopoles or beams which are mutually coherent with each other. Where there is more than one mutually coherent dipole, the different mutually coherent dipoles may also be mutually coherent; e.g., all monopoles of a quadrupole or some or all dipoles of n-pole illumination may be mutually coherent. Alternatively, it may be that at least one of the mutually coherent dipoles is not mutually coherent with at least another of the mutually coherent dipole(s). As such, the even plurality of monopoles of the n-pole illumination may comprise one or more coherence groups, wherein each coherence group comprises an even number subset of said plurality of monopoles which are all mutually coherent and are arranged in one or more dipoles. As such, opposite monopoles (constituting a mutually coherent dipole) are mutually coherent while non-opposite monopoles can, but do not have to be necessarily need to be, mutually coherent with each other.

As such, the method comprises a metrology apparatus, comprising: an illuminator being operable to generate illumination comprising an even plurality of monopoles arranged within an illumination angularly resolved plane in one or more coherence groups, wherein each coherence group comprises a respective at least one mutually coherent dipole of said even plurality of monopoles which are all at least pointwise mutually coherent; projection optics for projecting said illumination onto a periodic structure on a substrate at a substrate plane; a stop in a detection angularly resolved plane between the substrate plane and a detection plane, being operable to block or attenuate zeroth order reflection corresponding to all but one monopole for each said one or more coherence groups, the zeroth order reflection being comprised within scattered radiation resulting from illumination of said periodic structure; and a detector for detecting at least a portion of the scattered radiation at the detection plane.

The illumination may comprise coherent radiation, whereby each monopole per mutually coherent dipole is coherent. Alternatively, the illumination may be partially coherent. In the latter case, the each monopole per mutually coherent dipole may be pointwise mutually coherent. The concept of pointwise coherence is described, for example, in WO2020126257A1 which is incorporated herein by reference.

Briefly, pointwise mutually coherent describes an arrangement where corresponding points in the pupil of each of the monopoles of a mutually coherent dipole are spatially coherent with each other, but while each of these points is not necessary coherent with other points within its respective monopole. As such, each of the monopoles of a pair is (in terms of coherence profile) a translation in the pupil plane of the other monopole of the pair.

The intensity of opposite monopoles (of each mutually coherent dipole) should be substantially the same and/or any difference in intensity should be known (so that it can be corrected for). This is similar to the preference for having balanced illumination quadrant intensity for the two illumination quadrants in known diffraction based metrology methods.

Figure 7 illustrates three illumination arrangements according to concepts disclosed herein. Figure 7(a) illustrates an illumination pupil 705 for a dipole illumination arrangement. The illumination pupil 705 comprises a single mutually coherent dipole 700a, 700b, where the monopoles are diagonally opposed (e.g., 45 degrees with respect to the measurement directions). Again, the shading in Figures 7(a)-7(c) is provided to distinguish each diffraction pattern (respectively for each monopole) in later drawings; the monopoles are mutually coherent (e.g., fully coherent or pointwise coherent) and (at least preferably) of substantially equal intensity.

Figure 7(b) illustrates an illumination pupil 705' for a first quadrupole illumination arrangement. The illumination pupil 705' comprises a first mutually coherent dipole 700a', 700b' and a second mutually coherent dipole 700c', 700d', and where all of the monopoles 700a', 700b', 700c', 700d' are mutually coherent. Therefore, as with the dipole example of Figure 7(a), the illumination comprises a single coherence group of monopoles.

Figure 7(c) illustrates an illumination pupil 705" for a second quadrupole illumination arrangement, where the monopoles are only pairwise coherent. The illumination pupil 705' comprises a first mutually coherent dipole 700a", 700b" (a first coherence group of monopoles) and a second mutually coherent dipole 700c", 700d" (a second coherence group of monopoles). As indicated by the crosses in the Figure, the first mutually coherent dipole 700a", 700b" is not coherent with the second mutually coherent dipole 700c", 700d" (the white + indicating a first coherence state and the black x indicating a second coherence state). In both of the first and second quadrupole illumination arrangement, the monopoles may be aligned with the pupil coordinate system defined by the measurement directions.

In the detection arm of such arrangement, the specular reflections (zeroth order reflections) and a single-sided spectrum comprising the diffraction orders of interest (e.g., at least the +1 and -1 diffraction orders for X-direction and Y-direction metrology) of the scattered light are captured. All but one of the specular reflections is blocked (or at least suppressed) for each coherence group of mutually coherent monopoles, in the detection arm (e.g., at the detection pupil or detection angularly resolved plane in the detection arm between the substrate and detector). In this context, a coherence group is a group of the illumination monopoles which all have mutual coherence, and therefore may comprise any number of the mutually coherent dipoles comprised within the illumination profile. For example, in Figures 7(a) and Figure 7(b), there is one coherence group of two and four monopoles respectively and in Figure 7(c), there are two coherence groups each of two monopoles.

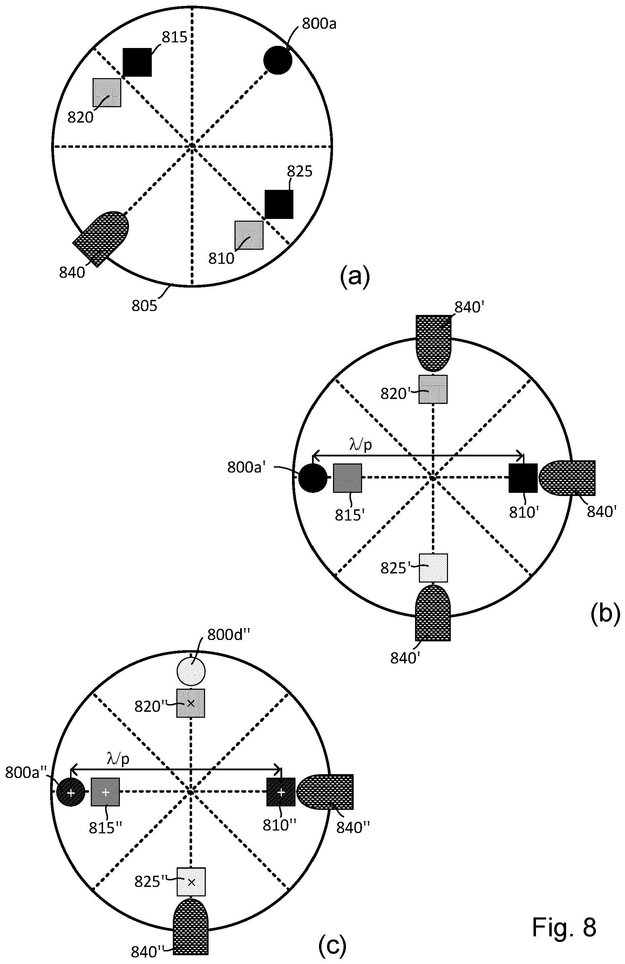

Figure 8 is a schematic of the detection pupil for the three embodiments illustrated in Figure 7. As with Figure 6, the circles denote the zeroth order reflection and squares denote the +/-1st order diffraction orders of interest (i.e., those captured within the detection NA), each being at a distance of $\lambda/p$ from the zeroth order reflection in the relevant measurement direction.

Figure 8(a) shows a detection pupil 805 corresponding to the dipole illumination arrangement of Figure 7(a). One of the specular reflections 800a is unblocked and allowed to propagate, the other is blocked by stop 840. It is an arbitrary choice as to which of the specular reflections is blocked; as such specular reflection 800b may be blocked and the specular reflection corresponding to the illumination monopole 700b allowed to propagate. Also shown are the diffraction orders of interest: +1X order 810, -1X order 815, +1Y order 820, and -1Y order 825.

Figure 8(b) shows a detection pupil 805' corresponding to the first quadrupole illumination arrangement of Figure 7(b). One of the specular reflections 800a' is unblocked and allowed to propagate, the other reflections are blocked by one or more stops 840'. Again, which one of the specular reflections is allowed to propagate is arbitrary. Also shown are the diffraction orders of interest: +1X order 810', -1X order 815', +1Y order 820', and -1Y order 825'.

Figure 8(c) shows the detection pupil 805" corresponding to the second quadrupole illumination arrangement of Figure 7(c). Two of the specular reflections 800a", 800d", i.e., one per mutually coherent dipole, are unblocked and allowed to propagate, the other two reflections are blocked by one or more stops 840". The choice as to which of the specular reflections is blocked per mutually coherent dipole is arbitrary. Also shown are the diffraction orders of interest: +1X order 810", -1X order 815", +1Y order 820", and -1Y order 825".

It can be appreciated that the maximum usable wavelength-over-pitch ratio for each of the two quadrupole embodiments extends up to (at least approximately) 2*NA,* where the detection NA *NA* is represented by the radius of the pupil 805, 805', 805" in Figure 8. Note that the pupil representation in Figure 8 is shown (for clarity) as having beam sizes and stops which are significantly greater in size with respect to the full detection NA than in a real setup. Therefore this ratio $\lambda$/p looks significantly less than 2*NA* in the drawing; this is only a limitation of the drawing.

The one or more (secondary) reflected orders which are blocked do not have to be blocked entirely. It is sufficient that these reflections are sufficiently suppressed such that their remaining power is lower than the power in the one or more primary (propagating) reflected orders (the reflected zeroth order(s) which are not blocked). When the blocking is only partial (i.e., the zeroth orders are only suppressed rather than fully blocked), the reconstructed field will also comprise one or more attenuated zeroth orders; these may be used to (partially) compensate aberrations. By not fully blocking, but only attenuating the secondary zeroth order(s), it is possible to reconstruct their optical complex field. Having this additional information can help in applying corrections to the diffraction orders which originate from that secondary zeroth order. A drawback of this is that there is a need to balance the photon budget on the camera; part of the photon budget needs to go to the light from that attenuated zeroth order, which in practice can be undesirable due to the limited dynamic range of the camera.

In all the embodiments described, the radiation captured within the detection NA (and not blocked) then propagates from the detection pupil towards the detector (e.g., a camera) where the resulting intensity is detected and recorded. Because each part of the diffracted field in the pupil (each diffraction order) has one corresponding mutually coherent zeroth order reflection, the intensity on the camera can be understood to comprise the sum of one or more fields (each corresponding to a respective coherence group), each having a single-sided spectrum.

A schematic representation of the intensity spectra obtained by the illumination and detection arrangements of Figures 7 and 8 are shown in Figure 9. Figure 9(a) illustrates the intensity spectrum of the detected intensity corresponding to the illumination and detection pupils of Figures 7(a) and 8(a). Figure 9(b) illustrates the intensity spectrum of the detected intensity corresponding to the illumination and detection pupils of Figures 7(b) and 8(b). Figure 9(c) illustrates the intensity spectrum of the detected intensity corresponding to the illumination and detection pupils of Figures 7(c) and 8(c). In each case, the labeling of the reflected and diffracted orders is the same as Figure 8.

Under this condition, where there are one or more fields having single sided spectra, a suitable phase retrieval algorithm may be used to reconstruct, in the detection pupil, the complex field or (for the multiple coherence group examples) the average sum of multiple complex fields where each field corresponds to a respective coherence group. The reconstructed fields are schematically shown in Figure 10, where Figure 10(a) is the reconstructed intensity pupil corresponding to the intensity spectrum of Figure 9(a), Figure 10(b) is the reconstructed intensity pupil corresponding to the intensity spectrum of Figure 9(b) and Figure 10(c) is the reconstructed intensity pupil corresponding to the intensity spectrum of Figure 9(c). Because the zeroth order reflection acts as a carrier for the diffracted radiation including the diffraction orders, they can be observed at different positions in the pupil. Proper digital filtering can now be applied to the reconstructed pupil to isolate each of the relevant diffraction orders of interest, so that they can be used for parameter of interest inference.

Examples of suitable algorithms for the phase retrieval may be found in (or adapted from), for example, a number of publications such as, for example: Nakajima, N., and T. Asakura. Two-dimensional phase retrieval using the logarithmic Hilbert transform and the estimation technique of zero information. Journal of Physics D: Applied Physics 19, no. 3 (1986): 319; Baek, Y., Lee, K., Shin, S., Park, Y., 2019. Kramers-Kronig holographic imaging for high-space-bandwidth product. Optica, OPTICA 6, 45-51; Baek, Y., Park, Y., 2021. Intensity-based holographic imaging via space-domain Kramers-Kronig relations, Nat. Photonics 15, 354-360; Shen, C., Liang, M., Pan, A., Yang, C., 2021. Non-iterative complex wave-field reconstruction based on Kramers-Kronig relations. Photon. Res., PRJ 9, 1003-1012. These documents are incorporated herein by reference. These are only examples and there are a large number of publications which describe suitable phase retrieval methods, as will be appreciated by the skilled person.

By way of a specific example in the non-coherent case, the (averaged) electric phase may be reconstructed from the modulus $|E(x)|$ of the electric field (as determined from the measured intensity) as:

$$\int \arg\!\left(e^{-iax} E_{REC}(x)\right) d\lambda = \mathcal{F}\left(\operatorname{sgn}(k_x)\mathcal{F}^{-1}\left(\int \ln|E(x)| \, d\lambda\right)\right)$$

where $a$ is the mask edge position in the pupil plane, and:

$$\operatorname{sgn}(k_x) = \begin{cases} -1, & \text{for } k_x < 0 \\ 0, & \text{for } k_x = 0 \\ 1, & \text{for } k_x > 0 \end{cases}$$

For the coherent case, the electric phase may be reconstructed from the modulus $|E(x)|$ of the electric field as:

$$\arg\!\left(e^{-iax} E_{REC}(x)\right) = \mathcal{F}\left(\operatorname{sgn}(k_x)\mathcal{F}^{-1}(\ln|E(x)|)\right)$$

There are of course single dimension (x) examples, and the concepts are equally applicable to the other dimension and simply adapted (as the skilled person will recognize) to the two-dimension case ($E_{REC}(x,y)$ or three-dimension case ($E_{REC}(x,y,\lambda)$).

For certain lambda-over-pitch combinations, the diffraction orders of interest (first orders) resulting from different monopoles may overlap in the detection pupil. To prevent this, the illumination profile (i.e., the position of the monopoles around the illumination pupil periphery) may be rotated with respect to the target (or *vice versa*) to create a more favorable distribution of diffraction orders in the pupil. For example, the rotation can be effected by providing for multiple sets of quadrupoles (or dipoles) at different locations in the illuminator, using only one set at a time. An alternative implementation may comprise rotating the wafer with respect to the illumination, for example as described (in a different context) in WO2021151754A1, which is incorporated herein by reference.

Figure 11 illustrates such an embodiment. Figure 11(a) shows a detection pupil 1105' corresponding to the first quadrupole illumination, but with the illumination effectively rotated with respect to the detection, as indicated by arrow 1150'. The unblocked specular reflection 1100a' as such is located in a position displaced along the periphery of the illumination pupil with respect to the example of Figure 8(b). Also shown are the diffraction orders of interest: +1X order 1110', -1X order 1115', +1Y order 1120', and -1Y order 1125'. When the illumination is rotated, the zeroth orders in the detection pupil will also move to a different angular location.

Figure 11(c) shows the detection pupil 1105" corresponding to the second quadrupole illumination arrangement, where the two unblocked specular reflections 1100a", 1100d" are shown rotated 1150". Also shown are the diffraction orders of interest: +1X order 1110", -1X order 1115", +1Y order 1120", and -1Y order 1125".

In each of the Figure 11 examples, the stops 1140', 1140" are configured to extend over a larger angular region to ensure that the in the detection pupil properly block the relevant zeroth order reflections after rotation. Alternatively, smaller stops may be provided which can be rotated (or are otherwise configurable) in correspondence with the illumination.

By rotating the locations of the set of quadrupoles with respect to the direction of the scattering of the target, more freedom in the wavelength-over-pitch range is provided for, without having diffraction orders overlap.

When using conventional diffraction based targets (e.g., $\mu DBO$ or $\mu DBF$ targets), the X- and Y-pads (sub-targets) are spatially separated (not only physically on the substrate, but also in the detected image, such that any distortions from aberrations should be sufficiently low). Figure 12 illustrates a method spatially filtering the measured intensity image before applying the phase retrieval algorithm so as to separate the contributions from different coherence groups. A target 1200 is measured to obtain an intensity spectrum 1210. A spatial filtering step 1220 may be performed to spatially filter the intensity image into two intensity sub-images 1230, each sub-image respectively relating to the X-pads and Y-pads. For each of these two sub-images, the field can be individually reconstructed 1240.

Such an approach may in particular provide an advantage for the second quadrupole illumination embodiment (or any embodiment with more than one coherence group). In such an embodiment, one coherence group generates the X-diffraction orders and the other coherence group generates the Y-diffraction orders. Spatially filtering the intensity image separates the contributions from the two coherence groups and allows for separate reconstruction of their respective fields. Such an additional spatial field filtering allows for easier separation of the X and Y first orders, even when they are (partially) overlapping in the pupil.

In an embodiment, digital processing (e.g., digital correction and/or filtering) may be performed on the reconstructed field (or local reconstructed field, see below) following any of the field reconstruction steps described herein. Such digital processing may correct for optical aberration within the metrology optics. Alternatively or in addition, such digital processing may correct for and/or reduce the impact of optical crosstalk from neighboring structures on the inferred parameter of interest.

The method may comprise defining a region of interest in a region which at least partially comprises at least portions of each of the diffraction orders of interest in the detection pupil plane. The region of interest may be a contiguous or non-contiguous region (e.g., multiple sub-regions) defining a subset of the full available detection NA. the region of interest may comprise non-contiguous sub-regions of equal area (or at least the sub-regions corresponding to each diffraction order of each complementary pair of diffraction orders) are of equal area as the parameter of interest will be inferred from a comparison of the diffraction orders of each complementary pair of diffraction orders. In an embodiment, each sub region (or at least the sub-regions corresponding to each diffraction order of each complementary pair of diffraction orders) may comprise the same amount, or same area of its respective diffraction order (purely for example, each sub regions may comprise a third, or a half of its respective diffraction order). However different size region of interest per measurement direction is also possible, e.g., to avoid neighboring structures in a particular direction. In an embodiment, each sub region (or at least the sub-regions corresponding to each diffraction order of each complementary pair of diffraction orders) may comprise corresponding portions of its respective diffraction order.

The parameter of interest may be determined from the digitally processed local reconstructed field corresponding to the region of interest. This step may comprise (digitally) reimaging the local reconstructed field (e.g., comprising sub-regions corresponding to each diffraction order of interest, such as a pair of complementary diffraction orders, e.g., +1/-1 diffraction orders (optionally a pair of complementary diffraction orders per X and Y direction of the substrate plane)). The parameter of interest may then be determined (e.g., optionally per direction) from a comparison or difference of the diffraction order of each pair (e.g., comparing the +1 order and -1 order). The phase of at least the diffraction orders of interest may be retrieved with respect to a phase of the corresponding specular component of its coherence group.

In an embodiment, the illumination may be provided using an illumination mode selector module. An illumination mode selector module is a form of spatial light modulation device or spatial light configuration device which enables control/configuration of the spatial pattern of the illumination pupil (i.e., the illumination configuration). However, other methods of configuring the illumination may be employed in such an apparatus, such as a more conventional spatial filter (e.g., as mounted to a filter wheel) with appropriate filtering configuration.

Using the concepts disclosed herein it is possible to perform non-iterative phase retrieval using partial coherent illumination. This opens the applicability of such methods to a broader range of light sources, such as the ones currently used in many metrology devices. An additional benefit is that it provides for a more relaxed alignment condition of the specular reflection with respect to the mask, allowing for a more robust practical implementation of the technique. In this manner, a method of full-field metrology (e.g., with phase retrieved) may be achieved in a single acquisition (i.e. single shot). An additional benefit is that no programmable mask is required, which simplifies the implementation of the method.

Figure 13 is a block diagram that illustrates a computer system 1300 that may assist in implementing the methods and flows disclosed herein. Computer system 1300 includes a bus 1302 or other communication mechanism for communicating information, and a processor 1304 (or multiple processors 1304 and 1305) coupled with bus 1302 for processing information. Computer system 1300 also includes a main memory 1306, such as a random access memory (RAM) or other dynamic storage device, coupled to bus 1302 for storing information and instructions to be executed by processor 1304. Main memory 1306 also may be used for storing temporary variables or other intermediate information during execution of instructions to be executed by processor 1304. Computer system 1300 further includes a read only memory (ROM) 1308 or other static storage device coupled to bus 1302 for storing static information and instructions for processor 1304. A storage device 1310, such as a magnetic disk or optical disk, is provided and coupled to bus 1302 for storing information and instructions.

Computer system 1300 may be coupled via bus 1302 to a display 1312, such as a cathode ray tube (CRT) or flat panel or touch panel display for displaying information to a computer user. An input device 1314, including alphanumeric and other keys, is coupled to bus 1302 for communicating information and command selections to processor 1304. Another type of user input device is cursor control 1316, such as a mouse, a trackball, or cursor direction keys for communicating direction information and command selections to processor 1304 and for controlling cursor movement on display 1312. This input device typically has two degrees of freedom in two axes, a first axis (e.g., x) and a second axis (e.g., y), that allows the device to specify positions in a plane. A touch panel (screen) display may also be used as an input device.

One or more of the methods as described herein may be performed by computer system 1300 in response to processor 1304 executing one or more sequences of one or more instructions contained in main memory 1306. Such instructions may be read into main memory 1306 from another computer-readable medium, such as storage device 1310. Execution of the sequences of instructions contained in main memory 1306 causes processor 1304 to perform the process steps described herein. One or more processors in a multi-processing arrangement may also be employed to execute the sequences of instructions contained in main memory 1306. In an alternative embodiment, hard-wired circuitry may be used in place of or in combination with software instructions. Thus, the description herein is not limited to any specific combination of hardware circuitry and software.

The term "computer-readable medium" as used herein refers to any medium that participates in providing instructions to processor 1304 for execution. Such a medium may take many forms, including but not limited to, non-volatile media, volatile media, and transmission media. Non-volatile media include, for example, optical or magnetic disks, such as storage device 1310. Volatile media include dynamic memory, such as main memory 1306. Transmission media include coaxial cables, copper wire and fiber optics, including the wires that comprise bus 1302. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 1304 for execution. For example, the instructions may initially be borne on a magnetic disk of a remote computer. The remote computer can load the instructions into its dynamic memory and send the instructions over a telephone line using a modem. A modem local to computer system 1300 can receive the data on the telephone line and use an infrared transmitter to convert the data to an infrared signal. An infrared detector coupled to bus 1302 can receive the data carried in the infrared signal and place the data on bus 1302. Bus 1302 carries the data to main memory 1306, from which processor 1304 retrieves and executes the instructions. The instructions received by main memory 1306 may optionally be stored on storage device 1310 either before or after execution by processor 1304.

Computer system 1300 also preferably includes a communication interface 1318 coupled to bus 1302. Communication interface 1318 provides a two-way data communication coupling to a network link 1320 that is connected to a local network 1322. For example, communication interface 1318 may be an integrated services digital network (ISDN) card or a modem to provide a data communication connection to a corresponding type of telephone line. As another example, communication interface 1318 may be a local area network (LAN) card to provide a data communication connection to a compatible LAN. Wireless links may also be implemented. In any such implementation, communication interface 1318 sends and receives electrical, electromagnetic or optical signals that carry digital data streams representing various types of information.

Network link 1320 typically provides data communication through one or more networks to other data devices. For example, network link 1320 may provide a connection through local network 1322 to a host computer 1324 or to data equipment operated by an Internet Service Provider (ISP) 1326. ISP 1326 in turn provides data communication services through the worldwide packet data communication network, now commonly referred to as the "Internet" 1328. Local network 1322 and Internet 1328 both use electrical, electromagnetic or optical signals that carry digital data streams. The signals through the various networks and the signals on network link 1320 and through communication interface 1318, which carry the digital data to and from computer system 1300, are exemplary forms of carrier waves transporting the information.

Computer system 1300 may send messages and receive data, including program code, through the network(s), network link 1320, and communication interface 1318. In the Internet example, a server 1330 might transmit a requested code for an application program through Internet 1328, ISP 1326, local network 1322 and communication interface 1318. One such downloaded application may provide for one or more of the techniques described herein, for example. The received code may be executed by processor 1304 as it is received, and/or stored in storage device 1310, or other non-volatile storage for later execution. In this manner, computer system 1300 may obtain application code in the form of a carrier wave.

Further embodiments are disclosed in the subsequent list of numbered clauses:

1. A metrology apparatus, comprising:

an illuminator being operable to generate illumination comprising an even plurality of monopoles arranged within an illumination angularly resolved plane in one or more coherence groups, wherein each coherence group comprises a respective at least one mutually coherent dipole of said even plurality of monopoles which are all at least pointwise mutually coherent;
projection optics for projecting said illumination onto a periodic structure on a substrate at a substrate plane;
a stop in a detection angularly resolved plane between the substrate plane and a detection plane, being operable to block or attenuate zeroth order reflection corresponding to all but one monopole for each said one or more coherence groups, the zeroth order reflection being comprised within scattered radiation resulting from illumination of said periodic structure; and
a detector for detecting at least a portion of the scattered radiation at the detection plane.

2. A metrology apparatus as defined in clause 1, further comprising a partial coherent illumination source for generating said illumination.

3. A metrology apparatus as defined in clause 1, further comprising a coherent illumination source for generating said illumination.

4. A metrology apparatus as defined in any preceding clause, wherein said monopoles are distributed evenly around within an illumination numerical aperture within the illumination angularly resolved plane.

5. A metrology apparatus as defined in clause 4, wherein each monopole of each mutually coherent dipole is on opposite sides of the illumination numerical aperture.

6. A metrology apparatus as defined in clause 4 or 5, wherein each monopole of each mutually coherent dipole is equidistant from a center of the illumination numerical aperture.

7. A metrology apparatus as defined in any of clauses 4 to 6, wherein all of said monopoles are equidistant from the center of the illumination numerical aperture.

8. A metrology apparatus as defined in any of clauses 4 to 7, wherein all of said monopoles are located at a peripheral region of the illumination numerical aperture.

9. A metrology apparatus as defined in any preceding clause, wherein said illumination comprises a single mutually coherent dipole forming a single coherence group.

10. A metrology apparatus as defined in clause 9, wherein said single mutually coherent dipole is aligned within said illumination numerical aperture along a line at 45 degrees with respect to a coordinate system defined by a first measurement direction and a second measurement direction of said periodic structure.

11. A metrology apparatus as defined in any of clauses 1 to 8, wherein said illumination comprises a first mutually coherent dipole and a second mutually coherent dipole, with both of said first mutually coherent dipole and second mutually coherent dipole forming a single coherence group.

12. A metrology apparatus as defined in any of clauses 1 to 8, wherein said illumination comprises a first mutually coherent dipole and a second mutually coherent dipole, the first mutually coherent dipole forming a first coherence group and the second mutually coherent dipole forming a second coherence group.

13. A metrology apparatus as defined in clause 11 or 12, wherein each said mutually coherent dipole is aligned within a respective axis of a coordinate system defined by a first measurement direction and a second measurement direction of said periodic structure.

14. A metrology apparatus as defined in any preceding clause, wherein said illuminator is rotatable with respect to the detection angularly resolved plane to mitigate and/or reduce overlap of diffraction orders of interest within the detection angularly resolved plane.

15. A metrology apparatus as defined in any preceding clause, further comprising a processor being operable to:

   non-iteratively reconstruct a field of said scattered radiation; and
   use said reconstructed field to determine a parameter of interest of the structure.

16. A metrology apparatus as defined in any preceding clause, wherein said processor is further operable to:
define a region of interest within said detection angularly resolved plane, said region of interest comprising at least a portion of each diffraction order of a plurality of diffraction orders of interest comprised within said scattered radiation, said plurality of diffraction orders of interest comprising at least one complementary pair of diffraction orders.

17. A metrology apparatus as define in clause 16, wherein said processor is further operable to:

   digitally reimage a local reconstructed field, the local reconstructed field comprising said reconstructed field cropped to correspond only to the region of interest; and
   determine said parameter of interest from the reimaged local reconstructed field.

18. A metrology apparatus as define in clause 17, wherein said processor is further operable to digitally process the local reconstructed field.

19. A metrology apparatus as defined in clause 18, wherein said digital processing comprises digital correction and/or filtering to correct for, reduce and/or remove optical aberration and/or correct for, reduce and/or remove the impact of optical crosstalk.

20. A metrology apparatus as defined in any of clauses 17 to 19, wherein said processor is further operable to:
determine said parameter of interest from a comparison of reimaged diffraction orders of each of the at least one complementary pair of diffraction orders, as reimaged from said local reconstructed field.

21. A metrology apparatus as defined in clause 20, wherein said region of interest comprises a corresponding proportion of each of the diffraction orders of each of the at least one complementary pair of diffraction orders.

22. A metrology apparatus as defined in any of clauses 16 to 21, wherein said region of interest comprises a plurality of sub-regions of interest, each comprising at least a portion of a respective one of said plurality of diffraction orders of interest.

23. A metrology apparatus as defined in clause 21, wherein each of said sub-regions of interest are equally dimensioned.

24. A metrology apparatus as defined in any of clauses 16 to 23, wherein said processor is further operable to, in said step of non-iteratively reconstructing a field, use a Kramers-Kronig based algorithm to retrieve a phase of at least the diffraction orders of interest.

25. A metrology apparatus as defined in clause 24, wherein said processor is further operable to retrieve the phase of at least the diffraction orders of interest with respect to a phase of the specular component.

26. A metrology apparatus as defined in any of clauses 16 to 25, wherein said parameter of interest is overlay or focus.

27. A metrology apparatus as defined in any preceding clause, further comprising a substrate holder for holding the substrate at the substrate plane.

28. A metrology method comprising:

obtaining metrology data relating to a measurement obtained by illuminating a periodic structure with illumination and capturing the resultant scattered radiation from said periodic structure at a detection plane, said scattered radiation passing through at least one detection angularly resolved plane between said periodic structure and detection plane, wherein said illumination comprises an even plurality of monopoles arranged within an illumination angularly resolved plane in one or more coherence groups, wherein each coherence group comprises a respective at least one mutually coherent dipole of said even plurality of monopoles which are all at least pointwise mutually coherent and wherein zeroth order reflection corresponding to all but one monopole for each said one or more coherence groups is blocked or attenuated within said detection angularly resolved plane;

non-iteratively reconstructing a field of said scattered radiation; and

using said reconstructed field to determine a parameter of interest of the structure.

29. A metrology method as defined in clause 28, wherein said illumination comprises partial coherent illumination and each monopole of a coherence group is pointwise mutually coherent.

30. A metrology method as defined in clause 28, wherein said illumination comprises coherent illumination.

31. A metrology method as defined in any of clauses 28 to 30, wherein said monopoles are distributed evenly around within an illumination numerical aperture within the illumination angularly resolved plane.

32. A metrology method as defined in clause 31, wherein each monopole of each mutually coherent dipole is on opposite sides of the illumination numerical aperture.

33. A metrology method as defined in clause 31 or 32, wherein each monopole of each mutually coherent dipole is equidistant from a center of the illumination numerical aperture.

34. A metrology method as defined in any of clauses 31 to 33, wherein all of said monopoles are equidistant from the center of the illumination numerical aperture.

35. A metrology method as defined in any of clauses 31 to 34, wherein all of said monopoles are located at a peripheral region of the illumination numerical aperture.

36. A metrology method as defined in any of clauses 28 to 35, wherein said illumination comprises a single mutually coherent dipole forming a single coherence group.

37. A metrology method as defined in clause 36, wherein said single mutually coherent dipole is aligned within said illumination numerical aperture along a line at 45 degrees with respect to a coordinate system defined by a first measurement direction and a second measurement direction of said periodic structure.

38. A metrology method as defined in any of clauses 28 to 35, wherein said illumination comprises a first mutually coherent dipole and a second mutually coherent dipole, with both of said first mutually coherent dipole and second mutually coherent dipole forming a single coherence group.

39. A metrology method as defined in any of clauses 28 to 35, wherein said illumination comprises a first mutually coherent dipole and a second mutually coherent dipole, the first mutually coherent dipole forming a first coherence group and the second mutually coherent dipole forming a second coherence group.

40. A metrology method as defined in clause 39, comprising spatially filtering the metrology data prior to said non-iteratively reconstructing a field step so as to separate respective contributions from the first coherence group corresponding to a first measurement direction and the second coherence group corresponding to a second measurement direction.

41. A metrology method as defined in clause 38, 39 or 40, wherein each said mutually coherent dipole is aligned within a respective axis of a coordinate system defined by a first measurement direction and a second measurement direction of said periodic structure.

42. A metrology method as defined in any of clauses 28 to 41, comprising effectively rotating the illumination with respect to the detection angularly resolved plane to mitigate and/or reduce overlap of diffraction orders of interest within the detection angularly resolved plane.

43. A metrology method as defined in any of clauses 28 to 42, comprising defining a region of interest within said detection angularly resolved plane, said region of interest comprising at least a portion of each diffraction order of a plurality of diffraction orders of interest comprised within said captured scattered radiation, said plurality of diffraction orders of interest comprising at least one complementary pair of diffraction orders.

44. A metrology method as defined in clause 43, comprising:

reimaging a local reconstructed field, the local reconstructed field comprising said reconstructed field cropped to correspond only to the region of interest; and
determining said parameter of interest from the reimaged local reconstructed field.

45. A metrology method as defined in clause 44, wherein said reimaging step comprises digitally reimaging the local reconstructed field.

46. A metrology method as defined in clause 44 or 45, comprising performing digital processing on the local reconstructed field.

47. A metrology method as defined in clause 46, wherein said digital processing comprises digital correction and/or filtering to correct for, reduce and/or remove optical aberration and/or correct for, reduce and/or remove the impact of optical crosstalk.

48. A metrology method as defined in any of clauses 44 to 47, comprising determining said parameter of interest from a comparison of reimaged diffraction orders of each of the at least one complementary pair of diffraction orders, as reimaged from said local reconstructed field.

49. A metrology method as defined in clause 48, wherein said region of interest comprises a corresponding proportion of each of the diffraction orders of each of the at least one complementary pair of diffraction orders.

50. A metrology method as defined in any of clauses 43 to 49, wherein said region of interest comprises a plurality of sub-regions of interest, each comprising at least a portion of a respective one of said plurality of diffraction orders of interest.

51. A metrology method as defined in clause 50, wherein each of said sub-regions of interest are equally dimensioned.

52. A metrology method as defined in any of clauses 43 to 51, comprising, in said step of non-iteratively reconstructing a field, using a Kramers-Kronig based algorithm to retrieve a phase of at least the diffraction orders of interest.

53. A metrology method as defined in clause 52, wherein said phase of at least the diffraction orders of interest is retrieved with respect to a phase of the specular component.

54. A metrology method as defined in any of clauses 28 to 53, wherein said parameter of interest is overlay or focus.

55. A metrology method as defined in any of clauses 28 to 54, wherein said metrology data comprises intensity data.

56. A metrology method as defined in any of clauses 28 to 55, wherein said obtaining said metrology data comprises:

illuminating the periodic structure with said illumination;
capturing scattered radiation from said periodic structure as a result of said illuminating at a detection plane, said scattered radiation comprising illumination passing through the at least one angularly resolved plane between said periodic structure and detection plane, said detection angularly resolved plane; and
blocking or attenuating, within said detection angularly resolved plane, zeroth order reflection corresponding to all but one monopole for each said one or more coherence groups.

57. A computer program comprising program instructions operable to perform the method of any of clauses 28 to 56, or method of any of the clauses 61 to 63, when run on a suitable apparatus.

58. A non-transitory computer program carrier comprising the computer program of clause 57.

59. A processing device comprising:

a processor; and
the non-transitory computer program carrier of clause 58.

60. A metrology apparatus being operable to perform the method of any of clauses 28 to 56 or clauses 61 to 63.

61. A metrology method comprising:

obtaining metrology data relating to a measurement obtained by illuminating a periodic structure with dipole illumination and capturing the resultant scattered radiation from said periodic structure at a detection plane, said scattered radiation passing through at least one detection angularly resolved plane between said periodic structure and detection plane, wherein each monopole of the dipole illumination is symmetrically opposed within an illumination numerical aperture and aligned within the illumination numerical aperture along a line at 45 degrees with respect to a coordinate system defined by a first measurement direction and a second measurement direction of said periodic structure, the scattered radiation corresponding to each monopole being directed, at said detection angularly resolved plane, to a respective different region of said detection plane;

non-iteratively reconstructing a field of said scattered radiation; and

using said reconstructed field to determine a parameter of interest of the structure.

62. A metrology method as defined in clause 61, wherein said obtaining said metrology data comprises:

illuminating the periodic structure with said illumination;

capturing scattered radiation from said periodic structure as a result of said illuminating at a detection plane, said scattered radiation comprising illumination passing through the at least one angularly resolved plane between said periodic structure and detection plane, said detection angularly resolved plane;

diverting, at said detection angularly resolved plane, a first portion of said scattered radiation corresponding to a first monopole of said dipole illumination to a first portion of the detection plane; and

diverting, at said detection angularly resolved plane, a second portion of said scattered radiation corresponding to a second monopole of said dipole illumination to a second portion of the detection plane.

63. A metrology method as defined in clause 62, comprising using a two-fold wedge element to perform said diverting steps.

64. A metrology apparatus, comprising:

an illuminator being operable to generate dipole illumination wherein each monopole of the dipole illumination is symmetrically opposed within an illumination numerical aperture and aligned within the illumination numerical aperture along a line at 45 degrees with respect to a coordinate system defined by a first measurement direction and a second measurement direction of a periodic structure being measured;

projection optics for projecting said illumination onto the periodic structure on a substrate at a substrate plane;

a two-fold wedge element at a detection angularly resolved plane between said substrate plane and a detection plane, being operable to divert a first portion of said scattered radiation corresponding to a first monopole of said dipole illumination to a first portion of the detection plane; and divert a second portion of said scattered radiation corresponding to a second monopole of said dipole illumination to a second portion of the detection plane; and

at least one detector at the detection plane for detecting said first portion of the scattered radiation and said second portion of the scattered radiation.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of an inspection or metrology apparatus, embodiments of the invention may be used in other apparatus. Embodiments of the invention may form part of a mask inspection apparatus, a lithographic apparatus, or any apparatus that measures or processes an object such as a wafer (or other substrate) or mask (or other patterning device). The term "metrology apparatus" may also refer to an inspection apparatus or an inspection system. E.g. the inspection apparatus that comprises an embodiment of the invention may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference may have been made above to the use of embodiments of the invention in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch P of the metrology targets may be close to the resolution limit of the optical system of the scatterometer or may be smaller, but may be much larger than the dimension of typical product features made by lithographic process in the target portions C. In practice the lines and/or spaces of the overlay gratings within the target structures may be made to include smaller structures similar in dimension to the product features.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

**Claims**

1. A metrology apparatus, comprising:

    an illuminator being operable to generate illumination comprising an even plurality of monopoles arranged within an illumination angularly resolved plane in one or more coherence groups, wherein each coherence group comprises a respective at least one mutually coherent dipole of said even plurality of monopoles which are all at least pointwise mutually coherent;
    projection optics for projecting said illumination onto a periodic structure on a substrate at a substrate plane;
    a stop in a detection angularly resolved plane between the substrate plane and a detection plane, being operable to block or attenuate zeroth order reflection corresponding to all but one monopole for each said one or more coherence groups, the zeroth order reflection being comprised within scattered radiation resulting from illumination of said periodic structure; and
    a detector for detecting at least a portion of the scattered radiation at the detection plane.

2. A metrology apparatus as claimed in any preceding claim, wherein said monopoles are distributed evenly around within an illumination numerical aperture within the illumination angularly resolved plane.

3. A metrology apparatus as claimed in claim 2, wherein each monopole of each mutually coherent dipole is on opposite sides of the illumination numerical aperture.

4. A metrology apparatus as claimed in claim 2 or 3, wherein each monopole of each mutually coherent dipole is equidistant from a center of the illumination numerical aperture.

5. A metrology apparatus as claimed in any of claims 2 to 4, wherein all of said monopoles are located at a peripheral region of the illumination numerical aperture.

6. A metrology apparatus as claimed in any preceding claim, wherein said illumination comprises a single mutually coherent dipole forming a single coherence group.

7. A metrology apparatus as claimed in any of claims 1 to 6, wherein said illumination comprises a first mutually coherent dipole and a second mutually coherent dipole, with both of said first mutually coherent dipole and second mutually coherent dipole forming a single coherence group, or the first mutually coherent dipole forming a first coherence group and the second mutually coherent dipole forming a second coherence group.

8. A metrology apparatus as claimed in any preceding claim, further comprising a processor being operable to:

    non-iteratively reconstruct a field of said scattered radiation; and
    use said reconstructed field to determine a parameter of interest of the structure.

9. A metrology apparatus as claimed in claim 8, wherein said processor is further operable to: define a region of interest within said detection angularly resolved plane, said region of interest comprising at least a portion of each diffraction order of a plurality of diffraction orders of interest comprised within said scattered radiation, said plurality of diffraction orders of interest comprising at least one complementary pair of diffraction orders.

10. A metrology apparatus as claimed in claim 9, wherein said processor is further operable to:

digitally reimage a local reconstructed field, the local reconstructed field comprising said reconstructed field cropped to correspond only to the region of interest; and
determine said parameter of interest from the reimaged local reconstructed field.

11. A metrology apparatus as claimed in claim 10, wherein said processor is further operable to digitally process the local reconstructed field.

12. A metrology apparatus as claimed in claim 11, wherein said digital processing comprises digital correction and/or filtering to correct for, reduce and/or remove optical aberration and/or correct for, reduce and/or remove the impact of optical crosstalk.

13. A metrology apparatus as claimed in any of claims 10 to 12, wherein said processor is further operable to:
determine said parameter of interest from a comparison of reimaged diffraction orders of each of the at least one complementary pair of diffraction orders, as reimaged from said local reconstructed field.

14. A metrology apparatus as claimed in any of claims 9 to 13, wherein said processor is further operable to, in said step of non-iteratively reconstructing a field, use a Kramers-Kronig based algorithm to retrieve a phase of at least the diffraction orders of interest.

15. A metrology method comprising:

obtaining metrology data relating to a measurement obtained by illuminating a periodic structure with illumination and capturing the resultant scattered radiation from said periodic structure at a detection plane, said scattered radiation passing through at least one detection angularly resolved plane between said periodic structure and detection plane, wherein said illumination comprises an even plurality of monopoles arranged within an illumination angularly resolved plane in one or more coherence groups, wherein each coherence group comprises a respective at least one mutually coherent dipole of said even plurality of monopoles which are all at least pointwise mutually coherent and wherein zeroth order reflection corresponding to all but one monopole for each said one or more coherence groups is blocked or attenuated within said detection angularly resolved plane;
non-iteratively reconstructing a field of said scattered radiation; and
using said reconstructed field to determine a parameter of interest of the structure.

Fig. 1

Fig. 2

LA

SC1

SC3

0
-1    +1

CL

SC2

MT

Fig. 3

2

4

SM1

Z

X

PU

W

I

6

Z

8

λ

X

Fig. 4

Fig. 5

Fig. 6

705

700a

700b

(a)

700d'

705'

700a'

700b'

700c'

(b)

700d''

705''

700a''

700b''

700c''

(c)

$k_y$

$k_x$

Fig. 7

(a)

(b)

(c)

Fig. 8

(a)

(b)

(c)

Fig. 9

Fig. 10

Fig. 11

—1200

—1210

—1220

—1230

—1240

Fig. 12

Fig. 13

EP 4 610 725 A1

**EUROPEAN SEARCH REPORT**

Application Number

EP 24 15 9900

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2023/154255 A1 (KLA CORP [US]) 17 August 2023 (2023-08-17) * paragraphs [0034] - [0039]; figures 2A - 2C * | 1-15 | INV. G03F7/00 |
| A | "METROLOGY METHOD AND ASSOCIATED METROLOGY DEVICE", RESEARCH DISCLOSURE, KENNETH MASON PUBLICATIONS, HAMPSHIRE, UK, GB , vol. 719, no. 90 15 February 2024 (2024-02-15), XP007152364, ISSN: 0374-4353 Retrieved from the Internet: URL:https://www.researchdisclosure.com/database/RD719090 [retrieved on 2024-02-15] * the whole document * | 1-15 | |

TECHNICAL FIELDS SEARCHED (IPC)

G03F

The present search report has been drawn up for all claims

| Place of search | Date of completion of the search | Examiner |
|---|---|---|
| Munich | 9 October 2024 | Weckesser, Jens |

EPO FORM 1503 03.82 (P04C01)

## ANNEX TO THE EUROPEAN SEARCH REPORT
## ON EUROPEAN PATENT APPLICATION NO.

EP 24 15 9900

This annex lists the patent family members relating to the patent documents cited in  the above-mentioned European search report.
The members are as contained in the European Patent Office EDP file on
The European Patent Office is in no way liable for these particulars which are merely given for the purpose of information.

09-10-2024

| Patent document cited in search report | Publication date | Patent family member(s) | | Publication date |
|---|---|---|---|---|
| WO 2023154255 A1 | 17-08-2023 | CN | 117980692 A | 03-05-2024 |
| | | TW | 202348957 A | 16-12-2023 |
| | | US | 2023259040 A1 | 17-08-2023 |
| | | US | 2024329543 A1 | 03-10-2024 |
| | | WO | 2023154255 A1 | 17-08-2023 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6952253 B
- US 20100328655 A
- US 2011102753 A1
- US 20120044470 A
- US 20110249244 A
- US 20110026032 A
- EP 1628164 A
- US 451599
- US 11708678 B
- US 12256780 B
- US 12486449 B
- US 12920968 B
- US 12922587 B
- US 13000229 B
- US 13033135 B
- US 13533110 B
- US 13891410 B
- WO 2011012624 A
- US 20160161863 A
- US 20160370717 A1
- US 20190107781 A
- WO 2021121733 A1
- WO 2021121733 A
- WO 2020254041 A
- WO 2020126257 A1
- WO 2021151754 A1

### Non-patent literature cited in the description

- **NAKAJIMA, N.** ; **T. ASAKURA.** Two-dimensional phase retrieval using the logarithmic Hilbert transform and the estimation technique of zero information.. *Journal of Physics D: Applied Physics*, 1986, vol. 19 (3), 319
- **BAEK, Y.** ; **LEE, K.** ; **SHIN, S** ; **PARK, Y.** Kramers-Kronig holographic imaging for high-space-bandwidth product.. *Optica, OPTICA*, 2019, vol. 6, 45-51
- **BAEK, Y.** ; **PARK, Y.** Intensity-based holographic imaging via space-domain Kramers-Kronig relations. *Nat. Photonics*, 2021, vol. 15, 354-360
- **SHEN, C.** ; **LIANG, M.** ; **PAN, A.** ; **YANG, C.** Non-iterative complex wave-field reconstruction based on Kramers-Kronig relations.. *Photon. Res., PRJ*, 2021, vol. 9, 1003-1012